# DEMANDE DE BREVET EUROPEEN

(11) **EP 1 798 733 A1**
(43) Date de publication de la demande: **20.06.2007**
(21) Numéro de dépôt: 06023889.6
(22) Date de dépôt: 17.11.2006
(51) Int. Cl.: G11C 16/34

(54) **Procédé et dispositif de vérification de l'éxécution d'une commande d'écriture dans une mémoire**

(30) Priorité: 14.12.2005 FR 0512631
(71) Demandeur: STMICROELECTRONICS SA, 92120 Montrouge (FR)
(72) Inventeur: Kari, Ahmed, 83170 Tourves (FR); Moreaux, Christophe, 13109 Simiane (FR); Naura, David, 13100 Aix en Provence (FR); Rizzo, Pierre, 13100 Aix en Provence (FR)
(74) Mandataire: Marchand, André

(57) **Abrégé**

L'invention concerne un procédé d'exécution d'une commande d'écriture d'un mot binaire dans une mémoire programmable, comprenant des étapes d'écriture de chacun des bits (RB) dans un état programmé d'un mot binaire à écrire (D) dans une cellule mémoire correspondante de la mémoire, de lecture de chaque bit (MB) du mot écrit dans la mémoire (MEM) correspondant à un bit (RB) à l'état programmé du mot à écrire, de comparaison de chaque bit (RB) à l'état programmé du mot à écrire à un bit correspondant (MB) lu dans la mémoire, et de génération d'un signal d'erreur (ER) si au moins un bit du mot à écrire à l'état programmé est différent du bit correspondant lu. Application de l'invention notamment aux circuits intégrés pour carte à puce.

## Description

La présente invention concerne un circuit intégré comprenant une mémoire programmable électriquement et une unité de traitement pour exécuter des commandes de lecture et d'écriture de la mémoire.

La présente invention concerne notamment les circuits intégrés pour carte à puce avec ou sans contact ou encore les circuits intégrés utilisés dans des applications spécifiques telles que les compteurs kilométriques pour automobiles.

Selon les applications et le type de mémoire employé, il existe plusieurs modes d'écriture d'un mot dans une mémoire. Dans un premier mode d'écriture, les cellules mémoire prévues pour mémoriser les bits du mot à écrire sont préalablement effacées. Ensuite, les cellules mémoire correspondant aux bits à l'état programmé du mot à écrire sont programmées. Dans un second mode d'écriture, un mot est écrit dans la mémoire en programmant directement les cellules mémoire correspondant aux bits à l'état programmé du mot à écrire, sans opération d'effacement préalable. Ainsi, seules changent d'état les cellules mémoire qui étaient à l'état effacé avant la programmation et qui correspondent par leur rang à des bits à l'état programmé du mot à écrire. Ce mode d'écriture est notamment utilisé dans des compteurs de type boulier, par exemple des compteurs kilométriques pour automobile, ou dans des applications de mémorisation ou de comptage d'événements.

Dans certaines applications comme les puces sans contact, un lecteur émet des commandes d'écriture sous la forme d'ondes électromagnétiques à un circuit intégré alimenté électriquement à partir du champ radioélectrique rayonné par le lecteur. Dans ces applications, il peut se produire des erreurs de transmission en raison de perturbations électromagnétiques. Il peut également se produire des erreurs d'écriture dans la mémoire, en raison notamment d'une tension d'alimentation insuffisante du circuit intégré, lorsque ce dernier se trouve à la limite du champ radioélectrique rayonné par le lecteur. Il est donc souhaitable de s'assurer qu'une commande d'écriture a bien été exécutée par le circuit intégré.

Généralement, la vérification de l'exécution d'une commande d'écriture est effectuée en envoyant une commande de lecture au circuit intégré pour lire les cellules mémoire du mot qui a été écrit dans la mémoire. Dans le cas d'un circuit intégré de carte à puce sans contact, il est nécessaire d'attendre le compte rendu d'écriture émis par le circuit intégré avant de transmettre la commande de lecture de vérification. Il faut ensuite attendre la réception du mot lu en réponse à la commande de lecture, et comparer le mot lu avec le mot à écrire. Certains circuits intégrés ne comprennent qu'un seul amplificateur de lecture (sense amplifier). La lecture d'un mot doit donc être effectuée bit par bit. L'écriture d'un mot en mémoire incluant l'exécution d'une telle procédure de vérification peut donc avoir une durée relativement longue.

Par ailleurs, certains circuits intégrés supportent les deux modes d'écriture décrits précédemment. Dans le mode d'écriture avec effacement préalable, la vérification de l'écriture nécessite de vérifier l'égalité de la valeur de chaque bit du mot à écrire et du mot lu après écriture. Dans le mode d'écriture sans effacement préalable, cette procédure de vérification n'est pas applicable, du fait que certains bits à l'état effacé du mot à écrire peuvent être au contraire à l'état programmé dans le mot lu après écriture.

Ainsi, la présente invention vise un procédé de vérification de l'exécution d'une commande d'écriture dans une mémoire d'un circuit intégré, qui ne fasse pas intervenir l'émetteur de la commande d'écriture.

Un autre objectif de la présente invention est de prévoir un procédé de vérification de l'exécution d'une commande d'écriture dans une mémoire d'un circuit intégré, qui soit adapté à la vérification d'une commande d'écriture sans effacement préalable.

Encore un autre objectif de la présente invention est de prévoir un procédé de vérification de l'exécution d'une commande d'écriture, qui soit compatible avec les deux modes d'écriture avec et sans effacement préalable.

Ces objectifs sont atteints par la prévision d'un procédé d'exécution d'une commande d'écriture d'un mot binaire dans une mémoire programmable, comprenant une étape d'écriture de chacun des bits dans un état programmé d'un mot binaire à écrire dans une cellule mémoire correspondante de la mémoire.

Selon l'invention, le procédé comprend des étapes consistant à :
- lire chaque bit du mot écrit dans la mémoire correspondant à un bit à l'état programmé du mot à écrire, et
- comparer chaque bit à l'état programmé du mot à écrire à un bit correspondant lu dans la mémoire.

Selon un mode de réalisation de l'invention, le mot est écrit dans la mémoire, sans effacement préalable des cellules mémoire dans lesquelles les bits du mot à écrire sont mémorisés.

Alternativement, le procédé comprend des étapes consistant à :
- préalablement à l'étape d'écriture, effacer les cellules mémoire dans lesquelles les bits du mot à écrire sont à mémoriser,
- à la suite de l'étape d'écriture, lire chaque bit du mot écrit dans la mémoire, et
- comparer chaque bit lu à un bit correspondant du mot à écrire.

Selon un mode de réalisation de l'invention, un paramètre de configuration détermine si l'écriture d'un mot dans la mémoire est effectuée avec ou sans effacement préalable des cellules mémoire dans lesquelles les bits du mot à écrire sont mémorisés, le procédé comprenant des étapes consistant à :
- lire la valeur du paramètre de configuration, et
- comparer à un bit correspondant lu dans la mémoire, chaque bit du mot à écrire, ou seulement chaque bit à l'état programmé du mot à écrire, suivant la valeur du paramètre de configuration.

Selon un mode de réalisation de l'invention, le procédé comprend une étape de génération d'un signal d'erreur si au moins un bit du mot à écrire à l'état programmé est différent du bit correspondant lu.

Selon un mode de réalisation de l'invention, le signal d'erreur est maintenu jusqu'à l'application d'un signal d'initialisation.

Selon un mode de réalisation de l'invention, le procédé comprend des étapes de réexécution de la commande d'écriture avec vérification de l'écriture, si au moins un bit du mot à écrire à l'état programmé est différent du bit correspondant lu.

Selon un mode de réalisation de l'invention, l'écriture du mot dans la mémoire est effectuée bit par bit, et la vérification de l'écriture est effectuée à la suite de la programmation de chaque bit à programmer du mot à écrire, et porte sur le bit écrit dans la mémoire.

L'invention concerne également un circuit intégré comprenant une mémoire programmable électriquement et une unité de traitement pour exécuter des commandes d'écriture d'un mot binaire dans la mémoire.

Selon l'invention, le circuit intégré comprend :
- des moyens de lecture pour lire chaque bit d'un mot écrit dans la mémoire correspondant à un bit dans un état programmé d'un mot à écrire dans la mémoire, et
- des moyens de comparaison pour comparer chaque bit à l'état programmé du mot à écrire à un bit correspondant lu dans la mémoire.

Selon un mode de réalisation de l'invention, le mot est écrit dans la mémoire, sans effacement préalable des cellules mémoire dans lesquelles les bits du mot à écrire sont mémorisés.

Alternativement, le mot est écrit dans la mémoire avec effacement préalable des cellules mémoire dans lesquelles les bits du mot à écrire sont mémorisés, les moyens de lecture lisant chaque bit d'un mot écrit dans la mémoire, et les moyens de comparaison comparant chaque bit à l'état programmé du mot à écrire à un bit correspondant lu dans la mémoire.

Selon un mode de réalisation de l'invention, un paramètre de configuration détermine si l'écriture d'un mot dans la mémoire est effectuée avec ou sans effacement préalable des cellules mémoire dans lesquelles les bits du mot à écrire sont mémorisés, le circuit intégré comprenant des moyens de mémorisation et de lecture de la valeur du paramètre de configuration, les moyens de comparaison comparant à un bit correspondant lu dans la mémoire, chaque bit du mot à écrire, ou seulement chaque bit à l'état programmé du mot à écrire, suivant la valeur du paramètre de configuration.

Selon un mode de réalisation de l'invention, le circuit intégré comprend des moyens pour générer un signal d'erreur si au moins un bit du mot à écrire à l'état programmé est différent du bit correspondant lu.

Selon un mode de réalisation de l'invention, le circuit intégré comprend des moyens pour maintenir le signal d'erreur jusqu'à l'application d'un signal d'initialisation aux moyens de génération d'un signal d'erreur.

Selon un mode de réalisation de l'invention, le circuit intégré comprend des moyens pour réexécuter la commande d'écriture avec vérification de l'écriture, si au moins un bit du mot à écrire à l'é'tat programmé est différent du bit correspondant lu.

Selon un mode de réalisation de l'invention, le circuit intégré comprend des circuits d'émission et de réception pour recevoir des commandes d'écriture et de lecture dans la mémoire sous la forme de signaux radioélectriques modulés, et un circuit d'alimentation électrique pour générer à partir des signaux radioélectriques reçus une tension d'alimentation du circuit intégré.

Selon un mode de réalisation de l'invention, la mémoire est une mémoire programmable et effaçable électriquement.

Selon un mode de réalisation de l'invention, la mémoire comprend un seul amplificateur de lecture.

Ces objets, caractéristiques et avantages ainsi que d'autres de la présente invention seront exposés plus en détail dans la description suivante de modes de réalisation de l'invention, faite à titre non limitatif en relation avec les figures jointes parmi lesquelles :
- la figure 1 représente sous la forme de blocs un circuit intégré pour carte à puce sans contact selon l'invention,
- les figures 2A et 2B sont des organigrammes illustrant le procédé selon l'invention,
- la figure 3 représente un circuit de vérification d'écriture selon l'invention,
- la figure 4 représente des chronogrammes illustrant le fonctionnement du circuit d'écriture.

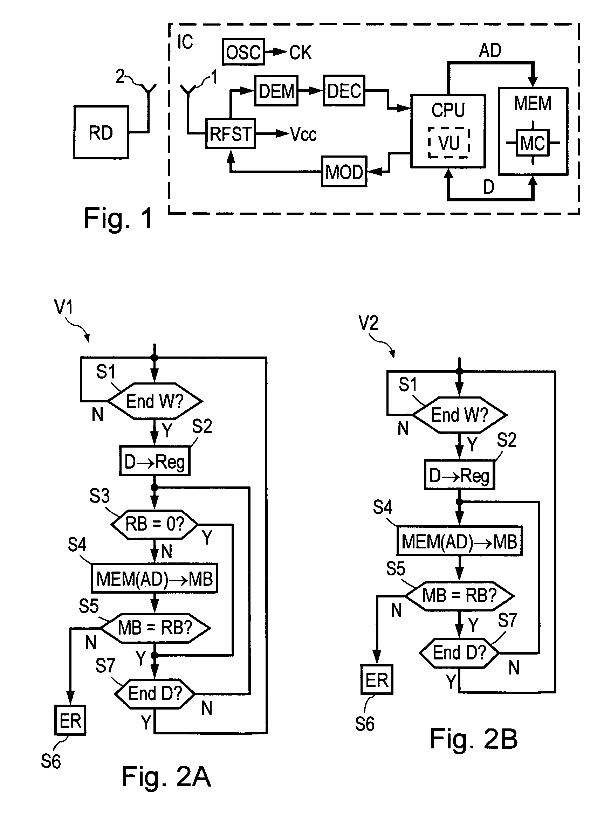

La figure 1 représente un circuit intégré IC pour carte à puce de type RFID (Radio-Frequency Identification). Le circuit intégré IC comprend une unité de traitement CPU connectée à une mémoire MEM. L'unité de traitement communique avec un lecteur externe RD couplé à une antenne 2, à l'aide d'une antenne 1 connectée à un étage radiofréquence RFST. L'étage RFST est connecté à un démodulateur DEM et à un modulateur MOD. Le démodulateur est connecté à un décodeur DEC qui fournit à l'unité de traitement CPU des commandes et des données, reçues et démodulées. Le modulateur module des données fournies par l'unité de traitement et applique les données modulées à l'étage RFST en vue de leur émission vers le lecteur RD.

Par ailleurs, l'étage RFST produit à partir d'un champ radioélectrique rayonné par le lecteur RD, une tension continue Vcc pour alimenter le circuit intégré IC. Le circuit intégré IC comprend également un générateur de signal d'horloge OSC qui fournit un signal d'horloge CK cadençant notamment le démodulateur, l'unité de traitement CPU et la mémoire MEM.

L'unité de traitement CPU est par exemple réalisée en logique câblée. La mémoire MEM comprend des cellules mémoire MC agencées selon des lignes horizontales et verticales et reliées à des lignes de mot et à des lignes de bit. La mémoire est par exemple de type EEPROM (Electrically Erasable Programmable Read Only Memory), les cellules mémoire étant effaçables et programmables électriquement. Pour des raisons d'économie de place notamment, la mémoire peut comprendre un seul amplificateur de lecture (sense amplifier). Dans ce cas, une commande de lecture d'un mot est exécutée bit par bit.

L'unité de traitement CPU est connectée à la mémoire MEM par des bus d'adresse et de données, permettant de transmettre une adresse physique AD à accéder dans la mémoire, et un mot D à mémoriser ou lu dans la mémoire à l'adresse physique.

Selon l'invention, l'unité de traitement CPU comprend une unité de vérification VU permettant de vérifier qu'une commande d'écriture dans la mémoire MEM a bien été exécutée. L'unité VU est activée pour effectuer une vérification d'écriture dès la fin de chaque écriture dans la mémoire et avant l'émission d'un éventuel message de compte rendu d'exécution de la commande d'écriture.

Les figures 2A et 2B sont des organigrammes illustrant des procédures de vérification V1, V2 conformes au procédé selon l'invention, ces procédures étant exécutées par l'unité VU. La procédure V1 représentée sur la figure 2A comprend les étapes suivantes :
- étape S1 : détection de fin d'écriture d'un mot D dans la mémoire MEM,
- étape S2 : chargement du mot à écrire D dans un registre Reg,
- étape S3 : test de la valeur programmée/effacée d'un bit du mot à écrire,
- étape S4 : lecture d'un bit MB du mot écrit dans la mémoire MEM,
- étape S5 : comparaison d'un bit RB du mot D avec un bit MB,
- étape S6 : génération d'un signal d'erreur ER, et
- étape S7 : détection de la fin du mot à écrire.

A l'étape S1, l'unité VU attend la fin de l'écriture d'un mot dans la mémoire MEM. A l'étape S2, le mot D reçu dans la commande d'écriture est chargé dans un registre Reg. Cette étape n'est pas nécessaire si le mot à écrire a été mémorisé dans un registre avant l'écriture du mot dans la mémoire.

Aux étapes S3 à S6, l'unité VU examine successivement chacun des bits du mot D. A l'étape S3, l'unité VU teste si le bit RB du mot D mémorisé dans le registre Reg est à l'état effacé ou programmé. Si le bit RB est à l'état programmé (à 1), l'unité VU lit le bit MB correspondant, c'est-à-dire de même rang, du mot écrit dans la mémoire MEM (étape S4). A l'étape suivante S5, l'unité VU teste l'égalité entre les bits RB et MB. Si ces deux bits sont différents, une erreur d'écriture s'est produite et l'unité VU lève un signal d'erreur ER (étape S6). Au contraire, si les bits RB et MB sont égaux, la procédure se poursuit à l'étape S7 où l'unité VU détermine si tous les bits du mot écrit ont été testés. Si tous les bits du mot écrit ont été testés, la procédure V1 se termine et l'unité VU se met en attente de la fin d'une nouvelle commande d'écriture (étape S1). Dans le cas contraire, l'unité VU effectue la vérification du bit suivant du mot écrit en retournant à l'étape S3.

La prévision de l'étape S4 est avantageuse si la mémoire est accessible bit par bit en lecture (mémoire à un seul amplificateur de lecture), car seuls sont lus en mémoire les bits MB qui correspondent à un bit RB à l'état programmé dans le mot à écrire D. Alternativement et en particulier si la mémoire est accessible par mot, le mot à vérifier, écrit dans la mémoire peut être lu au préalable et stocké temporairement dans un registre. Dans ce cas, la procédure de vérification V1 ne comporte pas d'étape S4 de lecture d'un bit dans la mémoire MEM.

La procédure de vérification V2 illustrée sur la figure 2B est identique à la procédure V1, mis à part que la procédure V2 est prévue pour tester systématiquement tous les bits du mot écrit. Ainsi, elle ne comprend pas d'étape S3 de test de la valeur effacée/programmée du bit RB du mot à écrire D, suivie d'un branchement conditionnel à l'étape S7.

L'une ou l'autre des procédures V1, V2 est sélectionnée par l'unité de traitement CPU en fonction d'un mode d'écriture. Ainsi, la procédure V1 est sélectionnée si l'écriture du mot à vérifier a été effectuée sans effacement préalable (mise à 0) des cellules mémoire utilisées pour mémoriser le mot. La procédure V1 ne vérifie que les bits RB du mot à écrire qui sont à l'état programmé (à 1). Au contraire, la procédure V2 qui vérifie tous les bits RB du mot à écrire, est effectuée à la suite d'une écriture en mode avec effacement préalable (mise à 0) des cellules mémoire utilisées pour mémoriser les bits du mot.

Il est à noter que la procédure de vérification V1 est compatible avec les deux modes d'écriture, avec et sans effacement préalable. Elle est simplement incomplète dans le cas du mode d'écriture avec effacement préalable, du fait que les bits à l'état effacé du mot à écrire ne sont pas testés.

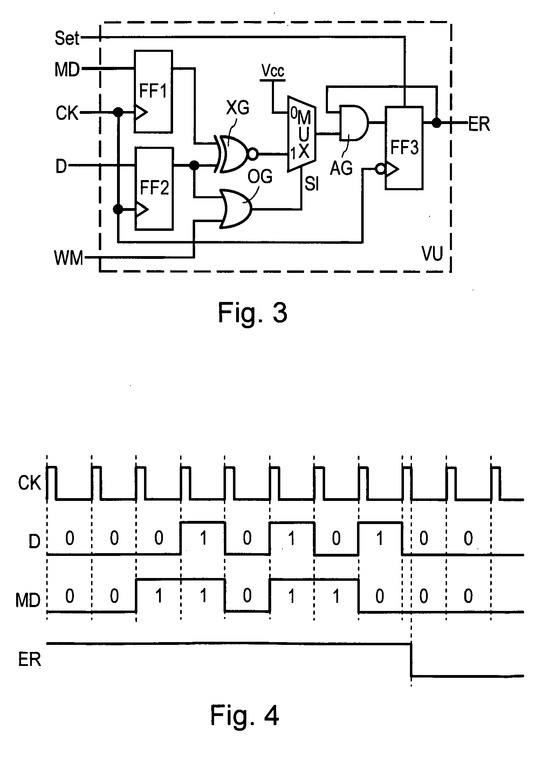

La figure 3 représente un mode de réalisation de l'unité VU sous la forme d'un circuit logique. L'unité VU comprend trois bascules (flip-flop) FF1, FF2, FF3 cadencées par un signal d'horloge CK. La bascule FF1 reçoit en entrée sous forme série, les bits MB lus dans la mémoire MEM du mot écrit à vérifier MD, tandis que la bascule FF2 reçoit en entrée également sous forme série, les bits RB du mot à écrire D mémorisé dans le registre Reg. Les sorties des deux bascules FF1, FF2 sont connectées aux entrées d'une porte logique XG de type OU exclusif inversée. La sortie de la porte XG est connectée à une entrée d'un multiplexeur MUX dont une autre entrée est connectée à la source d'alimentation Vcc. Le multiplexeur MUX est commandé par un signal de sélection S1 issu d'une porte logique OG de type OU dont les entrées sont connectées à la sortie de la bascule FF2 et à une entrée du circuit VU recevant un signal de mode d'écriture WM par exemple généré à partir d'un paramètre de configuration du circuit intégré IC. La sortie du multiplexeur est connectée à une entrée d'une porte logique AG de type ET dont la sortie est connectée à l'entrée de la bascule FF3. La sortie de la bascule FF3 fournit le signal d'erreur ER et est connectée à une entrée de la porte AG. La bascule FF3 est initialisée à 1 par un signal Set.

Le fonctionnement du circuit VU est illustré par les chronogrammes représentés sur la figure 4. A l'initialisation du circuit, la bascule FF3 est initialisée à 1. Il en résulte que le signal ER est également à 1. A chaque front montant du signal d'horloge CK, les bascules FF1, FF2 mémorisent la valeur d'un bit MB, RB de même rang du mot MD écrit dans la mémoire MEM, et du mot à écrire D, mémorisé dans le registre Reg. L'état des bascules FF1 et FF2 est comparé par la porte XG. Le signal de sortie de la porte XG est à 1 ou 0 selon que les bits MB, RB sont égaux ou non. Le multiplexeur MUX permet de forcer à 1 la sortie de la porte XG lorsque le bit RB du mot à écrire est à l'état effacé (à 0) et que le mode d'écriture est le mode sans effacement préalable (signal WM à 0). Tant que les bits MB et RB sont égaux, ou bien que le mode sans effacement préalable est sélectionné et que le bit RB est à l'état effacé (à 0), le signal de sortie ER de la bascule FF3 reste à 1. Au contraire, si les bits MB et RB sont différents, la sortie de la porte XG passe à 0 et le signal de sortie ER de la bascule FF3 passe également à 0. L'état à 0 de la bascule FF3, et donc du signal ER, est maintenu par la porte AG jusqu'à ce que le circuit VU soit initialisé par le signal Set.

Dans l'exemple de la figure 4, le signal WM est à 0. Les bits RB et MB du mot à écrire D et du mot écrit MD dans la mémoire MEM sont successivement égaux à :
D : 0001010100, et
MD : 0011011000.

Jusqu'au septième rang, soit les bits RB et MB des mots D et MD sont identiques, soit les bits RB sont à 0. Il en résulte que le signal d'erreur ER reste à 1. Au huitième rang, le bit RB du mot à écrire D est à 1, et le bit MB du mot MD est à 0. Par conséquent, le signal ER passe à 0, révélant ainsi une erreur d'écriture dans la mémoire MEM. Le signal ER reste dans cet état même si les bits suivants des mots D et MD sont identiques grâce à la porte AG.

Le signal d'erreur ER est par exemple utilisé par l'unité CPU pour constituer un message de compte rendu d'écriture qui est émis par le circuit intégré IC au lecteur RD. On peut prévoir également que l'unité de traitement CPU effectue plusieurs tentatives d'écriture du mot avant de signaler une erreur d'écriture dans le message de compte rendu.

Grâce à ces dispositions, la bonne exécution d'une commande d'écriture est vérifiée sans que le lecteur RD ait besoin d'envoyer une commande de lecture au circuit intégré IC, et sans que le circuit intégré IC envoie un autre message que celui qui est prévu en réponse à une commande d'écriture.

Si le circuit intégré IC est configurable en mode d'écriture sans effacement préalable, on peut prévoir que le circuit intégré puisse exécuter des commandes d'effacement d'un ou plusieurs mots dans la mémoire MEM. Dans ce cas, l'exécution d'une commande d'effacement peut également comprendre l'exécution d'une procédure de vérification telle que la procédure V2, pour vérifier que toutes les cellules mémoire adressées par la commande d'effacement ont bien été effacées. Le circuit de la figure 3 peut également être utilisé pour vérifier une commande d'effacement de la mémoire.

Il apparaîtra clairement à l'homme de l'art que l'invention est susceptible de diverses variantes de réalisation et applications. Ainsi, l'invention n'est pas limitée aux mémoires effaçables. Elle s'applique également aux mémoires non effaçables. Dans ce cas, seules les cellules mémoire correspondant à un bit à l'état programmé dans le mot à écrire doivent être vérifiées. En outre, la prévision d'un signal de mode d'écriture WM est inutile, la mémoire n'acceptant que le mode d'écriture sans effacement préalable.

En cas de détection d'une erreur d'écriture, il n'est pas indispensable de maintenir le signal d'erreur ou d'arrêter la procédure de vérification V1, V2. En effet, la détection d'une erreur peut être simplement signalée à l'unité de traitement qui peut alors effectuer une nouvelle tentative d'écriture du bit erroné, suivie d'une vérification de l'écriture.

L'écriture d'un mot dans la mémoire peut alternativement être effectuée bit par bit, et la vérification de l'écriture effectuée à la suite de la programmation de chaque bit à programmer du mot à écrire. Dans ce cas, la procédure de vérification ne comporte que les étapes S4 à S6.

Par ailleurs, la correspondance entre l'état programmé/effacé d'une cellule mémoire et la valeur correspondante 0 ou 1 du bit mémorisé par la cellule mémoire n'est qu'une simple convention. Il va de soi qu'une convention inverse peut être employée sans sortir du cadre de la présente invention.

L'invention s'applique plus généralement à tout dispositif comportant une mémoire programmable électriquement.

## Revendications

1. Procédé d'exécution d'une commande d'écriture d'un mot binaire dans une mémoire programmable (MEM), comprenant une étape d'écriture de chacun des bits (RB) dans un état programmé d'un mot binaire à écrire (D) dans une cellule mémoire (MC) correspondante de la mémoire,
**caractérisé en ce qu'**il comprend des étapes consistant à :
- lire chaque bit (MB) du mot écrit (MD) dans la mémoire (MEM) correspondant à un bit (RB) à l'état programmé du mot à écrire (D), et
- comparer chaque bit (RB) à l'état programmé du mot à écrire à un bit correspondant (MB) lu dans la mémoire.

2. Procédé selon la revendication 1, dans lequel le mot (D) est écrit dans la mémoire (MEM), sans effacement préalable des cellules mémoire (MC) dans lesquelles les bits (RB) du mot à écrire sont mémorisés.

3. Procédé selon la revendication 1, comprenant des étapes consistant à :
- préalablement à l'étape d'écriture, effacer les cellules mémoire (MC) dans lesquelles les bits (RB) du mot à écrire (D) sont à mémoriser,
- à la suite de l'étape d'écriture, lire chaque bit (MB) du mot écrit dans la mémoire, et
- comparer chaque bit lu (MB) à un bit correspondant (RB) du mot à écrire (D).

4. Procédé selon l'une des revendications 1 à 3, dans lequel un paramètre de configuration (WM) détermine si l'écriture d'un mot dans la mémoire (MEM) est effectuée avec ou sans effacement préalable des cellules mémoire (MC) dans lesquelles les bits (RB) du mot à écrire (D) sont mémorisés, le procédé comprenant des étapes consistant à :
- lire la valeur du paramètre de configuration, et
- comparer à un bit correspondant (MB) lu dans la mémoire, chaque bit (RB) du mot à écrire (D), ou seulement chaque bit à l'état programmé du mot à écrire, suivant la valeur du paramètre de configuration.

5. Procédé selon l'une des revendications 1 à 4, comprenant une étape de génération d'un signal d'erreur (ER) si au moins un bit du mot à écrire à l'état programmé est différent du bit correspondant lu.

6. Procédé selon la revendication 5, dans lequel le signal d'erreur (ER) est maintenu jusqu'à l'application d'un signal d'initialisation (Set).

7. Procédé selon l'une des revendications 1 à 6, comprenant des étapes de réexécution de la commande d'écriture avec vérification de l'écriture, si au moins un bit du mot à écrire à l'état programmé est différent du bit correspondant lu.

8. Procédé selon l'une des revendications 1 à 7, dans lequel l'écriture du mot (D) dans la mémoire (MEM) est effectuée bit par bit, et la vérification de l'écriture est effectuée à la suite de la programmation de chaque bit à programmer (RB) du mot à écrire (D), et porte sur le bit (MB) écrit dans la mémoire.

9. Circuit intégré (IC) comprenant une mémoire programmable électriquement (MEM) et une unité de traitement (CPU) pour exécuter des commandes d'écriture d'un mot binaire dans la mémoire,
**caractérisé en ce qu'**il comprend :
- des moyens de lecture (CPU, FF1) pour lire chaque bit (MB) d'un mot écrit dans la mémoire (MEM) correspondant à un bit (RB) dans un état programmé d'un mot à écrire (D) dans la mémoire, et
- des moyens de comparaison (XG) pour comparer chaque bit à l'état programmé du mot à écrire à un bit correspondant lu dans la mémoire.

10. Circuit intégré (IC) selon la revendication 9, dans lequel le mot (D) est écrit dans la mémoire (MEM), sans effacement préalable des cellules mémoire (MC) dans lesquelles les bits (RB) du mot à écrire sont mémorisés.

11. Circuit intégré (IC) selon la revendication 9, dans lequel le mot (D) est écrit dans la mémoire (MEM) avec effacement préalable des cellules mémoire (MC) dans lesquelles les bits du mot (RB) à écrire sont mémorisés, les moyens de lecture (CPU, FF1) lisant chaque bit (MB) d'un mot écrit dans la mémoire (MEM), et les moyens de comparaison (XG) comparant chaque bit à l'état programmé du mot à écrire à un bit correspondant lu dans la mémoire.

12. Circuit intégré (IC) selon l'une des revendications 9 à 11, dans lequel un paramètre de configuration (WM) détermine si l'écriture d'un mot dans la mémoire (MEM) est effectuée avec ou sans effacement préalable des cellules mémoire (MC) dans lesquelles les bits (RB) du mot à écrire (D) sont mémorisés, le circuit intégré comprenant des moyens de mémorisation et de lecture de la valeur du paramètre de configuration, les moyens de comparaison (XG) comparant à un bit correspondant (MB) lu dans la mémoire, chaque bit (RB) du mot à écrire (D), ou seulement chaque bit à l'état programmé du mot à écrire, suivant la valeur du paramètre de configuration.

13. Circuit intégré (IC) selon l'une des revendications 9 à 12, comprenant des moyens (FF3) pour générer un signal d'erreur (ER) si au moins un bit du mot à écrire à l'état programmé est différent du bit correspondant lu.

14. Circuit intégré (IC) selon la revendication 13, comprenant des moyens (AG) pour maintenir le signal d'erreur (ER) jusqu'à l'application d'un signal d'initialisation (Set) aux moyens de génération (FF3) d'un signal d'erreur.

15. Circuit intégré (IC) selon l'une des revendications 9 à 14, comprenant des moyens pour réexécuter la commande d'écriture avec vérification de l'écriture, si au moins un bit du mot à écrire à l'état programmé est différent du bit correspondant lu.

16. Circuit intégré (IC) selon l'une des revendications 9 à 15, comprenant des circuits d'émission et de réception (RFST, MOD, DEM, DEC) pour recevoir des commandes d'écriture et de lecture dans la mémoire (MEM) sous la forme de signaux radioélectriques modulés, et un circuit d'alimentation électrique (RFST) pour générer à partir des signaux radioélectriques reçus une tension d'alimentation du circuit intégré.

17. Circuit intégré (IC) selon l'une des revendications 9 à 16, dans lequel la mémoire (MEM) est une mémoire programmable et effaçable électriquement.

18. Circuit intégré (IC) selon la revendication 9, dans lequel la mémoire (MEM) comprend un seul amplificateur de lecture.
